# EUROPEAN PATENT APPLICATION

(11) **EP 1 548 830 A2**
(43) Date of publication of application: **29.06.2005**
(21) Application number: 04030261.4
(22) Date of filing: 21.12.2004
(51) Int. Cl.: H01L 27/00

(54) **Ligthing apparatus**

(30) Priority: 25.12.2003 JP 2003429017
(71) Applicant: Kabushiki Kaisha Toyota Jidoshokki, Kariya-shi, Aichi-ken (JP)
(72) Inventor: Kato, Yoshifumi, Kariya-shi Aichi-ken (JP)
(74) Representative: Leson, Thomas Johannes Alois, Dipl.-Ing.

(57) **Abstract**

A lighting apparatus includes a first organic electroluminescence device. The first organic electroluminescence device has a substrate, a first organic electroluminescence element, which is formed on the substrate, and a light emitting portion. At least one second organic electroluminescence device is stacked on the light emitting portion. The second organic electroluminescence device has a transparent substrate and a transparent second organic electroluminescence element, which is formed on the transparent substrate. Therefore, the lighting apparatus can freely set the illumination intensity.

## Description

### BACKGROUND OF THE INVENTION

The present invention relates to a lighting apparatus that uses an organic electroluminescence (EL) element.

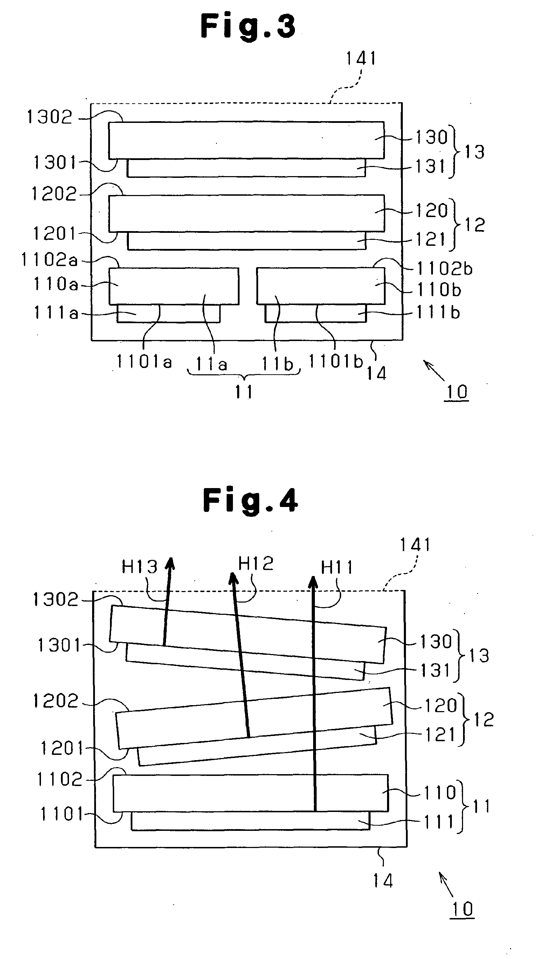

The lighting apparatus that uses an organic EL element is required to increase illumination intensity, that is, the amount of light emitted from the lighting apparatus. However, to increase the amount of light emitted from the lighting apparatus that uses an organic EL element, it is necessary to develop material contained in the organic EL element, to search for combination of materials, or to optimize the element structure. Therefore, it is difficult to develop a lighting apparatus that emits high intensity light (see "FPD international 2003 Backlight Corner Review", p.21, Fig. 4, Nikkei Business Publications. Inc.).

### SUMMARY OF THE INVENTION

Accordingly, it is an objective of the present invention to provide a lighting apparatus that has a new structure using an organic EL element and can freely set the illumination intensity.

To achieve the above objective, the present invention provides a lighting apparatus. The lighting apparatus includes a first organic electroluminescence device. The first organic electroluminescence device has a substrate, a first organic electroluminescence element, which is formed on the substrate, and a light emitting portion. At least one second organic electroluminescence device is stacked on the light emitting portion. The second organic electroluminescence device has a transparent substrate and a transparent second organic electroluminescence element, which is formed on the transparent substrate.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a cross-sectional view illustrating a first lighting apparatus 10 according to a first embodiment of the present invention;
Figs. 2(a) and 2(b) are cross-sectional views illustrating modified examples of the first lighting apparatus 10;
Fig. 3 is a cross-sectional view illustrating another modified example of the first lighting apparatus 10;
Fig. 4 is a cross-sectional view illustrating another modified example of the first lighting apparatus 10;
Fig. 5 is a cross-sectional view illustrating a second lighting apparatus 20 according to a second embodiment of the present invention;
Fig. 6 is a cross-sectional view illustrating a modified example of the second lighting apparatus 20;
Fig. 7 is a cross-sectional view illustrating a third lighting apparatus 30 according to a third embodiment of the present invention; and
Fig. 8 is a cross-sectional view illustrating a modified example of the third lighting apparatus 30.

### DETAILED DESCRIPTION OF THE PREFERRED EMBODIMENTS

First embodiment of the present invention will now be described. In each figure, like or the same members are given like numbers. Each figure shows a schematic view in which the dimension (ratio) differs from the actual lighting apparatus.

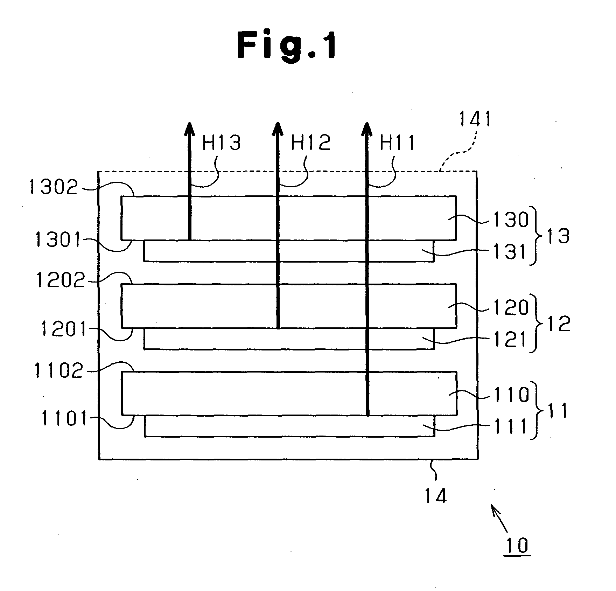

As shown in Fig. 1, a first lighting apparatus 10 includes a first organic EL device 11, a second organic EL device 12, and one more second organic EL device 13. The second organic EL devices 12, 13 are arranged on the light exiting side of the first organic EL device 11. The first lighting apparatus 10 includes a housing 14, which covers the organic EL devices 11, 12, and 13.

In this embodiment, the second organic EL devices (12, 13) refer to the organic EL devices 12, 13 other than the first organic EL device 11. In a structure that employs a plurality of second organic EL devices, a second organic EL device 12 may have different structure from the other second organic EL device 13. The second organic EL device 12 may have substantially the same structure as the other second organic EL device 13. The first organic EL device 11 may have substantially the same structure as at least one of the second organic EL devices 12, 13. That is, the terms first and second are used to distinguish the position of the organic EL devices 11, 12, and 13 in the lighting apparatus 10.

The first organic EL device 11 includes a transparent substrate 110 and a first organic EL element 111. The organic EL device 11 is formed by placing the organic EL element 111 on one (a surface 1101) of surfaces of the transparent substrate 110. The first organic EL device 11 is bottom emission type. The transparent substrate 110 has a contact surface 1101 (hereinafter, referred to as an EL surface 1101 upon request), which contacts the organic EL element 111, and a light emitting surface 1102 opposite to the contact surface 1101. The light emitting surface 1102 functions as a light emitting portion of the organic EL device 11.

In this embodiment, a transparent component (for example, the transparent substrate 110) may be anything as long as the component has permeability to light that enters from the side (the EL surface 1101, light incident side) opposite to the light exiting side (the light emitting surface 1102). The transparent component may have permeability at all the wavelengths of the incident light or may have permeability at part of the wavelength. The transparent component may have different transmittance at each wavelength of light.

The second organic EL device 12 includes a transparent substrate 120 and a second organic EL element 121. The second organic EL device 12 is bottom emission type. The transparent substrate 120 has a contact surface (EL surface) 1201, which contacts the second organic EL element 121, and a light emitting surface 1202 opposite to the contact surface 1201. The light emitting surface 1202 functions as a light emitting portion of the second organic EL device 12. The second organic EL device 12 is stacked on the light emitting surface 1102 of the first organic EL device 11.

Another second organic EL device 13 includes a transparent substrate 130 and a second organic EL element 131. The second organic EL device 13 is bottom emission type. The transparent substrate 130 has a contact surface (EL surface) 1301, which contacts the second organic EL element 131, and a light emitting surface 1302 opposite to the contact surface 1301. The light emitting surface 1302 functions as a light emitting portion of the second organic EL device 13. The second organic EL device 13 is stacked on the light emitting surface 1202 of the second organic EL device 12. That is, the second organic EL device 13 is also stacked on the light emitting surface 1102 of the first organic EL device 11 via the second organic EL device 12.

An arrow H11 in Fig. 1 represents a normal line of the contact surface (EL surface) 1101. The direction shown by the arrow H11 represents a direction in which light is emitted from the first organic EL device 11. The first organic EL device 11 also emits light in directions other than that shown by the arrow H11. That is, the organic EL element 111 generally has isotropic light emission characteristics. However, light used in the lighting apparatus 10 is the light emitted mainly in the direction of the arrow H11 and the light emitted in a specific angular range around the arrow H11. Hereinafter, the direction indicated by the arrow H11 will be referred to as the light emitting direction (front direction) of the organic EL device 11.

Arrows H12 and H13 in Fig. 1 indicate the light emitting direction of the second organic EL devices 12 and 13, respectively.

When voltage is applied to each organic EL device 11, 12, or 13, the associated organic EL element 111, 121, or 131 emits light. That is, the light emitted from each organic EL element 111, 121, and 131 refers to light generated by applying voltage to the associated organic EL element 111, 121, and 131, respectively.

The organic EL devices 11, 12, and 13 (the organic EL elements 111, 121, and 131) may either be connected to separate drive circuits or the same drive circuit. The organic EL devices 11, 12, and 13 may either be connected in parallel or in series with one another. Two of the three organic EL devices 11, 12, and 13 may be connected to the same drive circuit, or connected in parallel or in series with each other.

The housing 14 is provided with a window 141, which is located in the vicinity of the second organic EL devices 13. The window 141 functions as a light exiting portion, which permits light emitted from the organic EL devices 11, 12, and 13, that is, the light output from the second organic EL device 13, to be emitted outside the housing 14.

To obtain light output from the organic EL device 13, the window 141 is preferably located at a position that permits transmission of not only light emitted from the organic EL element 131 of the organic EL device 13, but also light emitted from the organic EL devices 11 and 12. That is, light output from the organic EL device 13 includes not only light emitted from the organic EL device 13, but also light that enters the organic EL device 13 from the other organic EL devices 11, 12 and output from the light emitting surface 1302 after being transmitted through the organic EL device 13. For example, as shown in Fig. 1, the contact surfaces (EL surfaces) 1101, 1201, and 1301 of the transparent substrates 110, 120, and 130 are arranged parallel to one another so that the light emitting directions of the organic EL devices 11, 12, and 13 are parallel to one another, and the window 141 is arranged in the light emitting direction.

The window 141 may be constituted by any member that is transparent to light as long as the member permits light output from the organic EL device 13 to be transmitted to the outside of the lighting apparatus 10 (outside of the housing 14).

The window 141 need not be a substantial member. That is, part (for example, the transparent substrate 130 in Fig. 1) of or the entire organic EL device 13 may be exposed to the outside. Furthermore, part of or the entire organic EL devices 11, 12 may be exposed to the outside.

The housing 14 preferably includes a mechanism (securing mechanism) for securing the organic EL devices 11, 12, and 13 to a predetermined position in the lighting apparatus 10. As for the securing mechanism, a known mechanism for securing a member may be employed upon request. The securing mechanism may secure the organic EL devices 11, 12, and 13 at a predetermined position of the lighting apparatus 10 by sandwiching part of (preferably the edges of) or the entire transparent substrates 110, 120, and 130 of the organic EL devices 11, 12, and 13 in the housing 14. The organic EL devices 11, 12, and 13 may be secured to the housing 14 or to a joint portion provided in the housing 14 with an adhesive. A member made of shock absorbing material (for example, foam polystyrene or plastic member) or molded to be able to hold the organic EL devices 11, 12, and 13 may be provided in the housing 14. In this case, the organic EL devices 11, 12, and 13 are arranged in accordance with the member.

### (Operation)

The operation of the lighting apparatus 10 will now be described. When voltage is applied to each of the organic EL elements 111, 121, and 131, the element 111, 121, or 131 emits light. The light is emitted toward the outside of the lighting apparatus 10 within a predetermined angular range around the associated normal line H11, H12, or H13 indicated by the arrows in Fig. 1. That is, the direction indicated by each normal line H11, H12, or H13 is referred to as the reference or front direction.

Light emitted from the first organic EL element 111 is transmitted through the second organic EL device 12 and the second organic EL device 13 and is emitted to the outside of the lighting apparatus 10 from the window 141 as shown by the arrow H11.

Light emitted from the second organic EL element 121 is transmitted through the second organic EL device 13 located in the vicinity of the window 141 and is emitted to the outside of the lighting apparatus 10 from the window 141 as shown by the arrow H12.

Light emitted from the second organic EL element 131 located closest to the window 141 is not transmitted through other organic EL devices 11, 12 and is emitted to the outside of the lighting apparatus 10 from the window 141 as shown by the arrow H13.

The advantages of the lighting apparatus 10 will now be described.

### (First Advantage: The lighting apparatus 10 permits a user to freely set the illumination intensity.)

Adjusting the illumination intensity of the lighting apparatus 10 is easier than a lighting apparatus that includes only one organic EL device. Therefore, the lighting apparatus 10 achieves the illumination intensity that cannot be achieved by the lighting apparatus that includes only one organic EL device.

As described above, to obtain high intensity light with only one organic EL element, it is necessary to select organic luminescent material or develop new material.

When voltage greater than or equal to a predetermined value is applied to the only one organic EL device or current greater than or equal to a predetermined value is supplied to the only one organic EL device to emit light having a predetermined intensity, T-T annihilation or S-S annihilation might become noticeable. As a result, the emitted wavelength might be different from the expected wavelength. Furthermore, the lifetime of the elements might be shortened or defects might become easily generated.

Therefore, it is difficult to achieve high illumination intensity with the conventional lighting apparatus. In other words, the illumination intensity that is practically obtained with the conventional lighting apparatus is limited.

In contrast, the lighting apparatus 10 is made by the organic EL devices 11, 12, and 13, which are substantially available at this time. That is, the second organic EL devices 12, 13 are each constituted by the transparent substrate 120 or 130 and the transparent organic EL element 121 or 131. The second organic EL devices 12, 13 are then combined with the first organic EL device 11 as shown in Fig. 1. If the desired illumination intensity cannot be achieved with the structure shown in Fig. 1, another second organic EL device may be combined with the lighting apparatus 10 to achieve the desired illumination intensity.

Therefore, the lighting apparatus 10 are used within a range in which the lifetimes of the organic EL elements 111, 121, and 131 are not shortened immediately.

The lighting apparatus of the present invention is not limited to the structure shown in Fig. 1, and the number of the second organic EL devices 12, 13 may be changed.

The lighting apparatus 10 achieves the illumination intensity that cannot be achieved with the conventional lighting apparatus.

In the prior art, unless there is a single organic EL device that emits desired intensity, new organic luminescent material or a new element structure had to be developed.

In contrast, with the lighting apparatus 10, the desired illumination intensity is achieved by only changing the number of the second organic EL devices 12, 13. This is because since the second organic EL devices 12, 13 are each constituted by the transparent substrate 120 or 130 and the transparent organic EL element 121 or 131, light emitted from all the organic EL devices 11, 12, and 13 is emitted outside the lighting apparatus 10 from the window 141.

As described above, the lighting apparatus 10 permits the user to freely set the illumination intensity by adjusting the number of the second organic EL devices 12, 13. The lighting apparatus 10 achieves the illumination intensity that could not be achieved with the conventional lighting apparatus that uses only one organic EL device.

### (Second Advantage: The lighting apparatus 10 can express several colors.)

The lighting apparatus 10 can express a color that cannot be expressed with the lighting apparatus that uses only one organic EL device by setting each organic EL device 11, 12, or 13 to emit light a color which is different from a color of at least one of the other organic EL devices 11, 12, and 13.

For example, by setting the organic EL device 11 to emit red light, the organic EL device 12 to emit green light, and the organic EL device 13 to emit blue light, and adjusting the amount of light emitted from the devices 11, 12, and 13, the color of light emitted outside of the lighting apparatus 10 from the window 141 becomes white.

The lighting apparatus 10 can also express colors other than white. The organic EL devices 11, 12, and 13 may be set to emit the same color of light.

### (Third Advantage: The lighting apparatus 10 does not become unusable easily, and can be repaired easily.)

The lighting apparatus 10 can substantially function as a lighting apparatus even if one or more of the organic EL devices 11, 12, and 13 are damaged.

For example, even if one or more of the organic EL devices 11, 12, and 13 stop emitting light, the lighting apparatus 10 can substantially function as a lighting apparatus as long as the other organic EL devices 11, 12, and 13 emit light. The performance (illumination intensity) equivalent to the initial performance of the lighting apparatus 10 is obtained by changing the organic EL device 11, 12, or 13 that stopped emitting light. That is, as compared to a lighting apparatus that is constituted by only one organic EL device, there is less need for changing or repairing all components in the lighting apparatus 10.

### (Fourth Advantage: An organic EL device that cannot be employed in the lighting apparatus constituted by only one organic EL device can be employed.)

The lighting apparatus 10 illuminates with light output from the second organic EL device 13 located closest to the window 141, that is, with the total of light emitted from the organic EL devices 11, 12, and 13. Therefore, the lighting apparatus 10 is less likely to be a defective unit by uneven luminance or a dark spot that has been generated or will be generated in one or more of the organic EL devices 11, 12, and 13.

In the case with the lighting apparatus constituted by only one organic EL device, the lighting apparatus cannot be used as a product if there is uneven luminance or a dark spot. Therefore, it is difficult to increase the yield of the lighting apparatus, which is constituted by only one organic EL device.

However, the lighting apparatus 10 emits light by combining the light emitted from the organic EL devices 11, 12, and 13. Therefore, even if there is uneven luminance or a dark sport in one or more of the organic EL devices 11, 12, and 13, the defect is compensated by light emitted from the other device 11, 12, or 13. That is, since combined light emitted from the three organic EL devices 11, 12, and 13 is emitted from each part of a reference surface, which is the window 141 in the first embodiment, the defect of each device 11, 12, or 13 is also averaged. Therefore, as compared to a lighting apparatus that is constituted by only one organic EL device, organic EL devices having low manufacturing accuracy can be used in the lighting apparatus 10. Even if a defect is generated in the organic EL device 11, 12, or 13 while using the lighting apparatus 10, the lighting apparatus 10 does not easily become substantially unusable.

### (Fifth Advantage: The organic EL devices 11, 12, and 13 may have the same structure.)

The organic EL devices 11, 12, and 13 may have substantially the same structure. That is, the lighting apparatus 10, which includes organic EL devices 11, 12, and 13 manufactured in the same process arranged as described above, has increased illumination intensity than a lighting apparatus that includes only one organic EL device.

The lighting apparatus 10 may be modified as described below. The following modification examples may be combined within a range where the examples do not contradict each other.

A lighting apparatus 10 according to a first modification example includes a member having light reflectivity in the housing 14. With this structure, part of or all the light that was not emitted toward the window 141 from the organic EL devices 11, 12, and 13 is directed toward the window 141 and is emitted outside the lighting apparatus 10 from the window 141. Therefore, as compared to a structure in which a light reflective portion is not provided, the amount of light emitted outside the lighting apparatus 10 increases. That is, the light exiting efficiency increases. A known art may be employed for the light reflective portion.

For example, part of or the entire inner surface of the housing 14 may be a mirror surface. To form such a mirror surface, the housing 14 may be formed of material having light reflectivity, or metal or resin member having light reflectivity may be adhered to or deposited on the inner surface of the housing 14.

The light reflective portion may be provided separately from the housing 14. For example, the light reflective portion may be provided with the securing mechanism, or may be provided with a member that does not block the light emitted from the organic EL devices 11, 12, and 13.

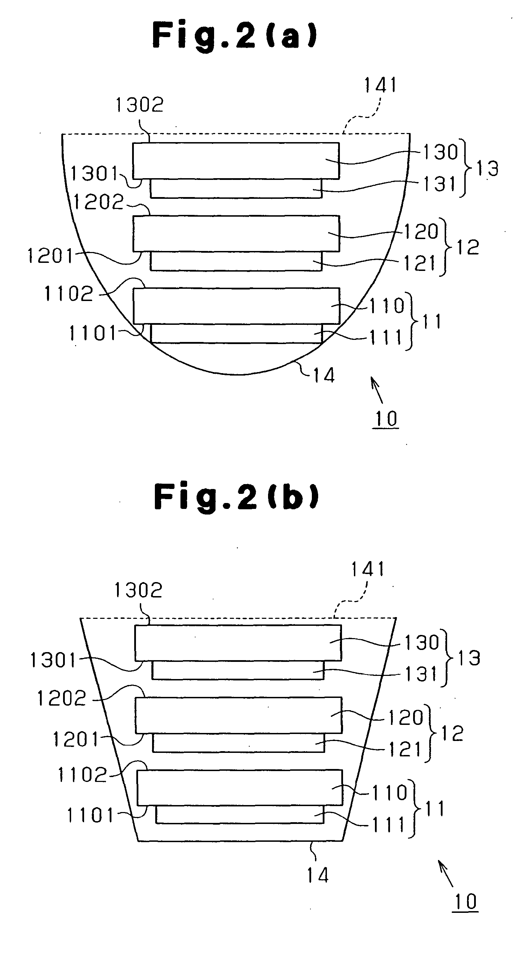

As shown in Figs. 2(a) and 2(b), the shape of the housing 14 (light reflective portion) may be designed such that the area of an imaginary plane substantially parallel to a plane along which the window 141 lies decreases as the distance from the window 141 increases. That is, the housing 14 becomes narrower toward the opposite side (lower side as shown in Figs. 2(a) and 2(b)) of the light exiting portion, which is the window 141. In this case also, the light emitted from the organic EL devices 11, 12, and 13 can be emitted outside the lighting apparatus 10 or converged at a predetermined position (focal point). The cross-section of the housing 14 may be parabolic as shown in Fig. 2(a) or a frustum (frustum of a cone or frustum of a pyramid) with the base on the window 141 as shown in Fig. 2(b). The cross-section of the housing 14 may be a cone (a circular cone or a pyramid) with the base on the window 141.

A lighting apparatus 10 according to a second modified example may be provided with a scattering member. With this structure, part of or all the light that was not emitted toward the window 141 from the organic EL devices 11, 12, and 13 is directed toward the window 141 and is emitted outside the lighting apparatus 10 from the window 141. Therefore, the scattering member is preferably located outside the space defined by the first organic EL device 11 (particularly, the organic EL element 111) and the window 141.

A known scattering member may be employed as the scattering member. For example, the scattering member can be formed by providing, in the housing 14, resin having different refractive index from the inner surface of the housing 14. The scattering member can be achieved by forming, on the light reflective portion (mirror surface), several concavity and convexity of the size that scatters light.

The window 141 may be formed with a light scattering member, which is a scattering sheet. This scatters light emitted from the lighting apparatus 10.

A third modified example is designed such that one or more of the organic EL devices 11, 12, and 13 are controlled to be selectively switched on and off separately from the other devices 11, 12, and 13. With this structure, the amount of light emitted from the lighting apparatus 10 can be adjusted. Each organic EL device 11, 12, or 13 may also be controlled to be selectively switched on and off independently. The lighting apparatus 10 may be designed such that the level of voltage applied to one or more of the organic EL devices 11, 12, and 13 can be adjusted.

To control one or more of the organic EL devices 11, 12, and 13 separately, a drive circuit is separated by providing a switch separate from that of the other organic EL device 11, 12, or 13, or providing a separate circuit for controlling the applied voltage. The lighting apparatus 10 can emit light by the amount suitable for the situation where the lighting apparatus 10 is used by further providing a sensor, which senses the brightness of the outside of the lighting apparatus 10, and an MPU, which controls the circuit for controlling the switch and the applied voltage to emit light in accordance with the detected brightness. The lighting apparatus 10 may be provided with a controller to emit light by the amount in accordance with an instruction from the user or an apparatus, which is not shown (for example, a liquid crystal display located at the front surface of the lighting apparatus 10). The controller may control the switch and the circuit.

A fourth modified example adjusts the refractive index between the organic EL devices 11, 12, and 13. For example, the refractive index between the organic EL device 11 and the organic EL device 12 is adjusted to be an intermediate value between the refractive indexes of the layers of the devices 11, 12 that face each other (the substrate 110 and the organic EL element 121). This increases the rate of light emitted from the organic EL device 11 furthest from the window 141 entering the organic EL device 13 closest to the window 141. For example, the organic EL devices 11 and 12 may be adhered to each other with an adhesive, and the refractive index obtained when the adhesive solidifies may be set to the above value. Alternatively, optical oil may be filled between the organic EL devices 11 and 12, and the refractive index of the optical oil may be set to the above value. When the organic EL devices 11 and 12 are adhered to each other with the optical oil, it is preferable that resin be applied to the edges of the adhered portion so that the oil do not flow out from the space between the devices 11 and 12.

The lighting apparatus 10 is not limited to have the structure in which the organic EL devices 11, 12, and 13 are separate from each other as shown in Fig. 1, but may have a structure in which the organic EL devices 11, 12, and 13 contact one another.

In the fifth modified example, the window 141 has several functions. The window 141 need not be substantially provided at all as described above. A glass may be provided as the window 141. However, some kind of functions can be applied to the window 141 by providing the scattering sheet to the window 141 as described above.

For example, if a sealing member generally used for the organic EL element is provided as the window 141, each of the organic EL devices 11, 12, and 13 need not be sealed. Therefore, as compared to a case where a sealing member is provided with each organic EL device 11, 12, or 13, the number of layers that light must pass is reduced. This increases the amount of light that is emitted outside the lighting apparatus 10 from the window 141.

As the sealing member, for example, material used for a passivation film or a sealing lid may be employed. When the sealing member is manufactured with these materials, moisture, gas, or other foreign objects that affects the organic EL devices 11, 12, and 13 are prevented from entering the lighting apparatus 10.

Examples of organic polymer material among the material that can be used as the sealing member include, fluorocarbon resin such as chlorotrifluoroethylene polymer, dichlorodifluoroethylene polymer, and copolymer of chlorotrifluoroethylene polymer and dichlorodifluoroethylene polymer, acrylic resin such as polymethylmethacrylate and polyacrylate, epoxy resin, silicon resin, epoxy silicone resin, polystyrene resin, polyester resin, polycarbonate resin, polyamide resin, polyimide resin, polyamide-imide resin, polyparaxylene resin, polyethylene resin, and polyphenylene oxide resin.

Examples of inorganic material among the material that can be used as the sealing member includes polysilazane, diamond membrane, amorphous silica, electrical insulation glass, metal oxide, metal nitride, metal carbide, and metal sulfide.

As for material that can be used as the sealing member, glass, stainless steel, metal (aluminum), plastic (polychlorotrifluoroethylene, polyester, polycarbonate) and ceramics may also be employed.

A moisture absorbent may be inserted in the lighting apparatus 10. Therefore, moisture is absorbed in case the moisture enters the lighting apparatus 10. The moisture absorbent is not particularly limited. For example, barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, or magnesium oxide may be used.

Gas that is inactive to the organic EL devices 11, 12, and 13 may be sealed in the lighting apparatus 10. The inactive gas refers to gas that does not react to the organic EL elements 111, 121, and 131. For example, a noble gas such as helium and argon or nitrogen gas may be employed.

A prism sheet may be provided at the window 141. The light converging function of the prism sheet can increase the amount of light emitted toward a particular direction from the lighting apparatus 10. As for the prism sheet, a prism sheet used in a known organic EL device or the liquid crystal display may be employed. Other optical member may be employed upon request.

When a member is provided at the window 141 as described above, the edge of the window 141 and the member is adhered to each other by applying sealant (an adhesive) between the edge of the window 141 and the member.
The edge of the window 141 and the member may be adhered to each other by thermal fusion bonding without using sealant. As the sealant, ultraviolet cured resin, thermosetting resin, or two liquid thermosetting resin may be used.

In the example of Fig. 1, the surface that connects the edges of the housing 14 is referred to as the window 141. However, the position of the window 141 is not limited to this. The window 141 may be located at least at the position of the light emitting surface (light exiting surface) 1302 of the second organic EL device 13 closest to the edges of the housing 14 or anywhere between the edges of the housing 14 and the light emitting surface 1302.

In the sixth modified example, the wavelength of light emitted from the lighting apparatus 10 may be limited, or a color conversion member for changing the wavelength may be provided. The color conversion member may be provided with one or more of the organic EL devices 11, 12, and 13.

As the color conversion member, a color filter that limits the wavelength of light emitted through the color conversion member, or a known member such as a wavelength conversion member that shifts the wavelength of light that has entered the color conversion member to a lower wavelength may be used.

The color conversion member may be provided with the window 141 or with the transparent substrates 110, 120, and 130 or the organic EL elements 111, 121, and 131.

The color filter adjusts the color of light by limiting the wavelength that can transmit through. As for the color filter, for example, known material such as cobalt oxide for blue filter, mixture of cobalt oxide and chromic oxide for green filter, and ferric oxide for red filter is used. The color filter may be formed on the transparent substrates 110, 120, and 130 using a known film forming technique such as vacuum deposition.

The wavelength conversion member may use a known wavelength conversion material. For example, a fluorescence conversion substance may be employed that converts light emitted from a light emitting layer to light having a low-energy wavelength. The type of the fluorescence conversion substance is selected in accordance with the wavelength of light that needs to be emitted from the target organic EL device 11, 12, or 13 and the wavelength of light emitted from the light emitting layer. The amount of the fluorescence conversion substance can be selected in accordance with the type of the fluorescence conversion substance within a range that does not generate concentration quenching. However, the amount of the fluorescence conversion substance is preferably 10⁻⁵ to 10⁻⁴ mol/litter for transparent resin (unhardened). Only one or several types of fluorescence conversion substance may be used. When using several types of fluorescence conversion substances, white light or neutral color light can be emitted by the combination of the fluorescence conversion substances besides blue light, green light, and red light. The examples of the fluorescence conversion substance are shown in the following (a) to (c).
(a) Fluorescence conversion substance that emits blue light when excited by ultraviolet light.
   Stilbene dye such as 1,4-bis(2-methylstyryl)benzene, trans-4,4'-diphenylstilbene, coumarin dye such as 7-hydroxy-4-methylcoumarin, and aromatic dimethylidin dye such as 4,4'-bis(2,2-diphenylvinyl)biphenyl.
(b) Fluorescence conversion substance that emits green light when excited by blue light.
   Coumarin dye such as 2,3,5,6-1H,4H-tetrahydro-8-trifluormethylquinolizino(9,9a,1-gh)coumarin(coumarin153).
(C) Fluorescence conversion substance that emits light having a wavelength of orange to red when excited by light having a wavelength of blue to green.

Cyanine dye such as 4-(dicyanomethylene)-2-methyl-6-(p-dimethylaminostyryl)-4H-pyran,4-(dicyanomethylene)-2-phenyl-6-(2-(9-julolidin)ethenyl)-4H-pyran,4-(dicyanomethylene)-2,6-di(2-(9-julolidin)ethenyl)-4H-pyran,4-(dicyanomethylene)-2-methyl-6-(2-(9-julolidin)ethenyl)-4H-pyran,4-(dicyanomethylene)-2-methyl-6-(2-(9-julolidin)ethenyl)-4H-thiopyran, pyridine dye such as 1-ethyl-2-(4-(p-dimethylaminophenyl)-1,3-butadienyl)-pyridinium-perchlorate (pyridine 1), xanthene dye such as rhodamine B, rhodamine 6G, and oxazine dye.

According to a seventh modified example, organic EL devices 11a and 11b, which are smaller than the organic EL device 11, are arranged instead of the organic EL device 11 as shown in Fig. 3. That is, the first organic EL device 11 is constituted by the organic EL devices 11a and 11b, which are arranged in a direction perpendicular to a direction from the first organic EL device 11 toward the second organic EL devices 12 and 13. The organic EL device 11a has a transparent substrate 110a and an organic EL element 111a, and the organic EL device 11b has a transparent substrate 110b and an organic EL element 111b. That is, each organic EL devices 11, 12, and 13 may be constituted by a single organic EL device or a plurality of organic EL devices arranged next one another. With this structure, the lighting apparatus 10 can be formed by the organic EL devices 11a, 11b each having a smaller area. The lighting apparatus 10 that has a broad light emitting area can be formed by arranging several organic EL devices.

According to an eighth modified example, one or more of organic EL devices 11, 12, and 13 may be top emission type. When the first organic EL device 11 or the second organic EL device 13 closest to the window 141 is top emission type, the number of transparent substrates 110, 120, 130 through which light emitted from the device 11 or 13 passes can be reduced. This increases the amount of light emitted from the lighting apparatus 10. In this case, the surface of the organic EL element 111, 121, or 131 opposite to the associated substrate 110, 120, or 130 functions as a light emitting surface of the organic EL device 11, 12, or 13.

According to a ninth modified example, the contact surfaces (EL surface) 1101, 1201, and 1301 of the organic EL devices 11, 12, and 13 are not parallel to one another as shown in Fig. 4. That is, the EL surface 1101, 1201, or 1301 of the organic EL device 11, 12, or 13 is not parallel to at least one of the other EL surfaces 1101, 1201, and 1301 of the organic EL devices 11, 12, and 13. The lighting apparatus of the ninth modified example can illuminate a range that is wider than the range that can be illuminated by the lighting apparatus 10 in Fig. 1. That is, the irradiation range of the lighting apparatus 10 is widened.

According to a tenth modified example, the housing 14 is eliminated. For example, the organic EL devices 11, 12, and 13 are adhered to one another with an adhesive. The housing 14 need not cover the organic EL devices 11, 12, and 13 but may be only a securing mechanism for securing the organic EL devices 11, 12, and 13 to a predetermined position.

According to an eleventh modified example, the substrate 110, 120, or 130 is eliminated from one or more of the organic EL devices 11, 12, and 13. With this structure, light that is transmitted through the devices 11, 12, and 13, which have no substrates 110, 120, and 130, is not attenuated by the substrates 110, 120, and 130.

When manufacturing the organic EL devices 11, 12, and 13 having no substrates 110, 120, and 130, the organic EL elements 111, 121, and 131 are formed on the substrates 110, 120, and 130 to be removable. After being formed, the organic EL elements 111, 121, and 131 are removed from the substrates 110, 120, and 130. In this case, the organic EL elements 111, 121, and 131 are adhered to the substrates 110, 120, and 130 with, for example, a volatile adhesive. The adhesive is volatilized to remove the organic EL elements 111, 121, and 131. An adhesive with small adhesion force may be employed.

After forming the organic EL elements 111, 121, and 131 on the substrates 110, 120, and 130, the substrates 110, 120, and 130 may be chipped off. For example, the substrates 110, 120, and 130 are chipped off from the organic EL devices 11, 12, and 13 by performing a known denudation technique such as sand blasting, dry etching, or wet etching on the substrates 110, 120, and 130 from the surfaces 1102, 1202, and 1302 of the substrates 110, 120, and 130 on which the organic EL elements 111, 121, and 131 are not formed.

When using the above denudation technique, the substrates 110, 120, and 130 need not be completely eliminated, but the thickness of the substrates 110, 120, and 130 may only be reduced. In this case, the organic EL devices 11, 12, and 13 are made thinner and therefore the thickness of the lighting apparatus 10 can be reduced.

With this modified example, the thickness of the substrates 110, 120, and 130 of the organic EL devices 11, 12, and 13 may be just enough for achieving the required durability of the organic EL devices 11, 12, and 13 when in use. This structure can be employed since the thickness of the substrates 110, 120, and 130 required during manufacture of the organic EL devices 11, 12, and 13 differs from the thickness required when in use. That is, the thickness of the substrates 110, 120, and 130 of the organic EL devices 11, 12, and 13 when in use may be thinner than the thickness of the substrates 110, 120, and 130 during manufacture of the organic EL devices 11, 12, and 13.

The examples of the structure and manufacture of each component of the lighting apparatus 10 will now be described.

### <Details of Components>

### (Transparent Substrates 110, 120, and 130)

The substrates 110, 120, and 130 are mainly plate-like transparent members for supporting the organic EL elements 111, 121, and 131, respectively.

The transparent substrates 110, 120, and 130 are members on which the organic EL elements 111, 121, and 131 are laminated, respectively. Therefore, at least the contact surfaces (EL surfaces) 1101, 1201, and 1301 of the transparent substrates 110, 120, and 130 are preferably flat and smooth.

As for the transparent substrates 110, 120, and 130, known members may be used as long as the members have the above mentioned property. In general, a ceramics substrate, such as a glass substrate, a silicon substrate, and a quartz substrate, or a plastic substrate is selected. A substrate that is formed of material used for forming a high refractive index transparent layer may also be employed. A substrate formed of a compound sheet, in which the same type or different types of substrates are combined, may be used.

The thickness of the transparent substrates 110, 120, and 130 may be set upon request, and the substrate of approximately less than or equal to 1 mm is generally employed.

The substrate 110 of the first organic EL device 11 need not be transparent if the organic EL device 11 is top emission type. In this case, material other than the above mentioned material for forming a transparent substrate can be employed for the substrate 110.

### (Organic EL elements 111, 121, and 131)

The organic EL elements 111, 121, and 131 are formed by sandwiching, between a transparent electrode (located on the substrates 110, 120, and 130) and a back plate (back electrode, (located opposite to the substrates 110, 120, and 130), an organic layer including organic luminescent material that emits light when voltage is applied to the electrodes. The organic EL elements 111, 121, and 131 may have a known layer structure of a known organic EL element and layers may be made of known material. Therefore, the organic EL elements 111, 121, and 131 can be manufactured by a known manufacturing method.

Each of the organic EL elements 121 and 131 of the second organic EL devices 12 and 13 must have a transparent back electrode.

The transparent electrode of the organic EL element 111 of the first organic EL device 11 must be located closer to the window 141 than the back electrode. When a light reflecting electrode is used for the back electrode of the organic EL element 111, the light emitted from the organic EL devices 11, 12, and 13 in a direction opposite to the window 141 can be directed toward the window 141. That is, the first organic EL element 111 includes a light transmitting layer, which functions as a luminous portion, and a back electrode, which functions as a light reflecting layer, located opposite to the luminous portion with respect to the light emitting surface 1102.

The organic layer may have any structure as long as the organic layer achieves at least the following functions. For example, the organic layer may have a laminated structure, in which each layer performs one of the following functions, or a single layer structure, which achieves the following functions.

### Electron Injection Function

Electrons are injected from the electrode (cathode). Electron injection property.

### Hole Injection Function

Holes are injected from the electrode (anode). Hole injection property.

### Carrier Transport Function

A function to transport at least one of electrons and holes. Carrier transport property.

A function for transporting electrons is referred to as an electron transport function (electron transport property) and a function for transporting holes is referred to as a hole transport function (hole transport property).

### Light Emitting Function

A function to generate excitons by recombining injected and transported electrons and holes (excitation state), and to emit light when returning to the base state.

As for the laminated structure of the organic layer, for example, a hole injection transport layer, a light emitting layer, and an electron injection transport layer may be provided in order from the anode side.

The hole injection transport layer is a layer for transporting holes from the anode to the light emitting layer. Material for forming the hole transport layer may be selected from, for example, small molecular material such as metal phthalocyanines such as copper phthalocyanine and tetra(t-butyl)copper phthalocyanine, nonmetal phthalocyanines, quinacridone compound, and aromatic amine such as 1,1-bis(4-di-p-tolylaminophenyl)cyclohexane,N,N'-diphenyl-N,N'-bis(3-methylphenyl)-1,1'-biphenyl-4,4'-diamine,N,N'-di(1-naphthyl)-N,N'-diphenyl-1,1'-biphenyl-4,4'-diamine, polymeric material such as polythiophene and polyaniline, polythiophene oligomer material, and other existing hole transport material.

The light emitting layer is a layer that is excited by recombining holes transported from the anode with electrons transported from cathode, and emits light when returning to the base state from the excited state. As material for the light emitting layer, fluorescent material or phosphorescent material may be employed. A dopant (fluorescent material or phosphorescent material) may be included in the host material.

Material for forming the light emitting layer may be, for example, small molecular material such as 9,10-diallylanthracene derivative, pyrene derivative, coronene derivative, perylene derivative, rubrene derivative, 1,1,4,4-tetraphenylbutadiene, tris(8-quinolinolate)aluminum complex, tris(4-methyl-8-quinolinolate)aluminum complex, bis(8-quinolinolate)zinc complex, tris(4-methyl-5-trifluoromethyl-8-quinolinolate)aluminum complex, tris(4-methyl-5-cyano-8-quinolinolate)aluminum complex, bis(2-methyl-5-trifluoromethyl-8-quinolinolate)[4-(4-cyanophenyl)phenolate]aluminum complex, bis(2-methyl-5-cyano-8-quinolinolate)[4-(4-cyanophenyl)phenolate]aluminum complex, tris(8-quinolinolate)scandium complex, bis[8-(para-tosyl)aminoquinoline]zinc complex, and cadmium complex, 1,2,3,4-tetraphenylcyclopentadiene, pentaphenylcyclopentadiene, poly-2,5-diheptyloxy-para-phenylenevinylene, coumarin phosphor, perylene phosphor, pyran phosphor, anthrone phosphor, porphyrin phosphor, quinacridone phosphor, N,N'-dialkyl substituted quinacridone phosphor, naphthalimide phosphor, and N,N'-dialyl substituted pyrrolopyrrole phosphor, polymeric material such as polyfluorene, polyparaphenylenevinylene, and polythiophene, and other existing luminescent material. When employing a host-guest structure, the host and the guest (dopant) may be selected from the above material.

The light emitting layer may be designed to emit light having a wavelength that is transmitted through a two-dimensional photonic crystal layer using one or more of the above listed materials.

The electron injection transport layer is a layer that transports electrons from the cathode (in this example, a back electrode) to the light emitting layer. Material for forming the electron transport layer may be, for example, 2-(4-biphenylyl)-5-(4-t-butylphenyl)-1,3,4-oxadiazole,2,5-bis(1-naphthyl)-1,3,4-oxadiazole, and oxadiazole derivative, bis(10-hydroxybenzo[h]quinolinolate)beryllium complex, and triazole compound.

The organic layer may include a layer that can be employed among known organic EL layers such as a buffer layer, a hole block layer, an electron injection layer, and a hole injection layer. The layers can be provided using a known material and a known manufacturing method. For example, the electron injection transport layer may be separated into an electron injection layer that is in charge of electron injection function and an electron transport layer that is in charge of electron transport function, which are then laminated to each other. Material for forming each layer may be selected upon request from known material in accordance with the function of the layer. That is, material for forming each layer may be selected from the above listed materials for forming the electron injection transport layer.

The electrode will now be described. The transparent electrode functions as anode or cathode.

The anode is an electrode for injecting holes into the organic layer. The anode may be made of any material as long as the above mentioned property is achieved. In general, the anode is made of known material such as metal, alloy, electrically conductive compound, or mixture thereof.

Examples of material used for forming the anode are listed below. Metal oxide or metal nitride such as indium tin oxide (ITO), indium zinc oxide (IZO), tin oxide, zinc oxide, zinc aluminum oxide, and titanium nitride; metal such as gold, platinum, silver, copper, aluminum, nickel, cobalt, lead, chrome, molybdenum, tungsten, tantalum, and niobium; alloy of the listed metals or alloy of copper iodide, conducting polymer such as polyaniline, polythiophene, polypyrrole, polyphenylenevinylen, poly(3-methylthiophene), and polyphenylenesulfide.

The anode must be formed sufficiently thin to permit light through when using metal or alloy among the above materials.

When the back electrode of the first organic EL element 111 is an anode, the anode is preferably a light reflecting electrode. In this case, material that has a property of reflecting light to be drawn outside is selected upon request among the above materials. In general, metal, alloy, or metallic compound is selected.

The anode may be made of one kind of the above mentioned material or a mixture of materials. The anode may have a multi-layered structure including layers of the same composition or different compositions.

The thickness of the anode depends on the material used but is generally selected within the range of about 5 nm to 1 µm, more preferably about 10 nm to 1 µm, further preferably about 10 nm to 500nm, particularly preferably about 10 nm to 300 nm, and further desirably about 10 nm to 200 nm.

The anode is formed by a known film forming technique such as spattering, ion plating, vacuum deposition, spin coating, and electron beam evaporation.

The sheet resistance of the anode is preferably less than or equal to several hundreds Ω/□ (ohm per square), or more preferably about 5 to 50 Ω/□ (ohm per square).

The surface of the anode may be subjected to UV/ozone cleaning or plasma cleaning.

The cathode is an electrode for injecting electrons to the organic layer.

Electrode material for forming the cathode is, for example, lithium, sodium, magnesium, gold, silver, copper, aluminum, indium, calcium, tin, ruthenium, titanium, manganese, chrome, yttrium, aluminum-calcium alloy, aluminum-lithium alloy, aluminum-magnesium alloy, magnesium-silver alloy, magnesium-indium alloy, lithium-indium alloy, sodium-potassium alloy, magnesium/copper mixture, and aluminum/aluminum oxide mixture. Material that can be employed as material for forming the anode may also be used for the cathode.

Like the anode, the cathode must be formed sufficiently thin to permit light through when using metal or alloy among the above materials. For example, an electrode formed by laminating transparent conductive oxide on a super thin film of magnesium-silver alloy may be employed. In such a cathode, a copper phthalocyanine doped buffer layer is preferably located between the cathode and the organic layer to prevent the light emitting layer from being damaged by plasma when spattering the conductive oxide.

When the back electrode of the first organic EL element 111 is a cathode, material that reflects light to be drawn outside is preferably selected. In general, metal, alloy, or metal compound is selected for the cathode.

The cathode may be made of single material or several materials. For example, if 5% to 10% of silver or copper is added to magnesium, the cathode is prevented from being oxidized and the adhesiveness between the cathode and an organic layer is improved.

The cathode may have a multi-layered structure including layers of the same composition or different compositions. For example, the cathode may have the following structure.

To prevent oxidation of the cathode, a protective layer made of corrosion resistant metal is located at part of the cathode that does not contact the organic layer.

As material for forming the protective layer, for example, silver or aluminum is preferably used.

Oxide, fluoride, or metal compound having small work function is inserted in the interface portion between the cathode and the organic layer to reduce the work function of the cathode.

For example, the material of the cathode is aluminum, and lithium fluoride or lithium oxide is inserted in the interface portion.

The cathode is formed by a known film forming technique such as vacuum deposition, spattering, ionization deposition, ion plating, and electron beam evaporation.

As for the organic EL element, besides the above mentioned examples, a known layer structure and material used for a known organic EL element may be employed upon request. Layer and material that are preferably employed will now be described.

### Insulating Layer

An insulating layer may be formed around the organic layer to prevent the transparent electrode and the back electrode from short circuiting.

As material for forming the insulating layer, material used for forming an insulating portion of a known organic EL element may be employed upon request. The insulating layer may be formed by a known technique such as spattering, electron beam evaporation, and chemical vapor deposition (CVD) .

### Auxiliary Electrode

Auxiliary electrode may be provided with the organic EL elements 111, 121, and 131. The auxiliary electrode is electrically connected to the anode and/or cathode. The auxiliary electrode is made of material having the volume resistivity that is lower than that of the electrode to which the auxiliary electrode is connected. When the auxiliary electrode is made of such material, the volume resistivity of the entire electrode to which the auxiliary electrode is provided can be decreased. This decreases the maximum difference of the level of current that flows through each point forming the organic layer as compared to a case where the auxiliary electrode is not provided.

Material for forming the auxiliary electrode may be, for example, tungsten (W), aluminum (Al), copper (Cu), silver (Ag), molybdenum (Mo), tantalum (Ta), gold (Au), chrome (Cr), titanium (Ti), neodymium (Nd), and alloy thereof.

Examples of alloy are Mo-W, Ta-W, Ta-Mo, Al-Ta, Al-Ti, Al-Nd, and Al-Zr. As material for forming an auxiliary wiring layer, compounds of metal and silicon, which are TiSi₂, ZrSi₂, HfSi₂, VSi₂, NbSi₂, TaSi₂, CrSi₂, WSi₂, CoSi₂, NiSi₂, PtSi, and Pd₂Si, are preferable. The auxiliary wiring layer may be formed by laminating the metal and silicon compounds.

In general, the thickness of the auxiliary electrode is preferably in a range of 100 nm to several tens of µm, and particularly preferably within the range of 200 nm to 5µm.

The reason for this is that when the thickness is less than 100 nm, the resistance value increases, which is not preferable for the auxiliary electrode. On the other hand, if the thickness exceeds several tens of µm, planarization of the auxiliary electrode becomes difficult. This might generate defect in the organic EL elements 111, 121, and 131.

The width of the auxiliary electrode is preferably within the range of 2 µm to 1,000 µm, and more preferably within the range of 5 µm to 300 µm.

The reason for this is that when the width is less than 2 µm, the resistance of the auxiliary electrode might increase. On the other hand, when the width exceeds 100 µm, the auxiliary electrode might hinder light from being transmitted to the outside.

### Sealing Member

Each of the organic EL devices 11, 12, and 13 may be sealed with the above mentioned sealing member.

### Layer Located Between Above Mentioned Layers

A layer for improving adhesion between layers of the organic EL elements 111, 121, and 131 and improving an electron injection property or a hole injection property may be provided.

For example, a cathode boundary layer (mixed electrode) may be provided between the organic EL elements 111, 121, and 131. The cathode boundary layer is formed by co-deposition of material for forming the cathode and material for forming the electron injection transport layer. This reduces an energy barrier for electron injection at the interface between the light emitting layer and the cathode. The adhesion between the cathode and the electron injection transport layer can also be improved.

The cathode boundary layer may be made of any material as long as the above mentioned property is achieved. The cathode boundary layer may be made of known material. For example, the cathode boundary layer may be made of alkali metal such as lithium fluoride, lithium oxide, magnesium fluoride, calcium fluoride, strontium fluoride, and barium fluoride, or alkali earth metal such as fluoride, oxide, chloride, and sulfide. The cathode boundary layer may be made of single material or several materials.

The thickness of the cathode boundary layer is about 0.1 nm to 10 nm, and preferably 0.3 nm to 3 nm.

The thickness of the cathode boundary layer may either be even or uneven. The cathode boundary layer may be island shaped and may be formed by known film forming technique such as vacuum deposition.

A layer (block layer) for preventing transmission of holes, electrons, or excitons may be provided in at least one of the interfaces between above mentioned layers. For example, a hole block layer may be provided adjacent to the cathode side of the light emitting layer to prevent holes from transmitting through the light emitting layer so that holes efficiently recombine with the electrons in the light emitting layer. Material for forming the hole block layer may be, but not limited to, for example, triazole derivative, oxadiazole derivative, BAlq, and phenanthroline derivative.

A layer (buffer layer) for reducing an injection barrier for holes or electrons may be provided in at least one of the interfaces between above mentioned layers. For example, the buffer layer may be inserted between the anode and the hole injection transport layer, or between the anode and the organic layer laminated adjacent to the anode to reduce the injection barrier for the hole injection. The buffer layer may be made of, but not limited to, existing material such as copper phthalocyanine.

### Doping to Hole Injection Transport Layer or Electron Injection Transport Layer

Organic luminescent material (dopant) such as fluorescent material or phosphorescent material may be doped in the hole injection transport layer or the electron injection transport layer so that the layers also emit light.

### Doping Alkali Metal or Alkali Metal Compound to Layer Adjacent to Cathode

When using metal such as aluminum for the cathode, alkali metal or alkali metal compound may be doped in a layer adjacent to the cathode to reduce the energy barrier between the cathode and the light emitting layer. When metal or metal compound is added, the organic layer is reduced and anion is generated. This promotes injection of electrons and lowers the applied voltage. Alkali metal compound may be, for example, oxide, fluoride or lithium chelate.

A second lighting apparatus 20 according to a second embodiment of the present invention will now be described. The second lighting apparatus 20 has the same structure as the first lighting apparatus 10 except that the areas of the substrates 110, 120, and 130 are changed, and can be modified in the same manner as the first lighting apparatus 10.

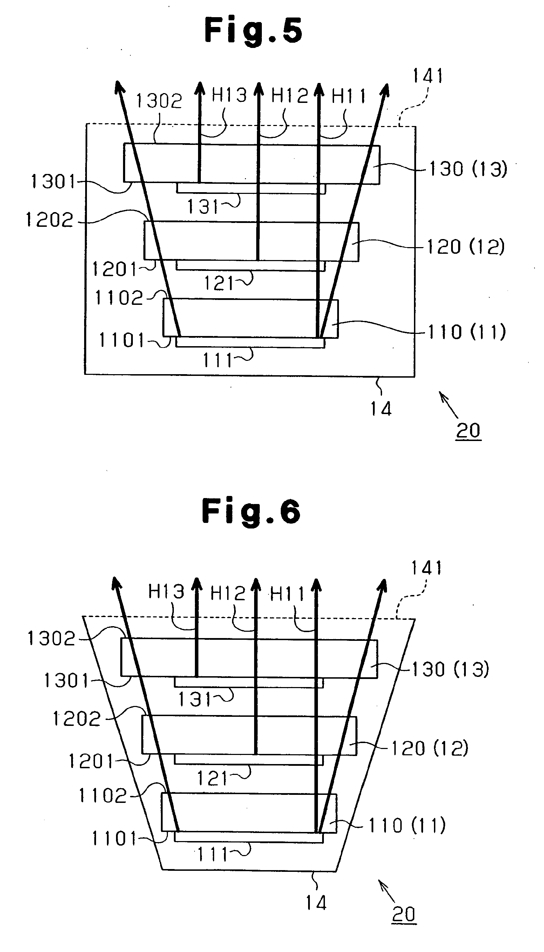

As shown in Fig. 5, the area of the transparent substrate 120 is greater than the area of the transparent substrate 110, and the area of the transparent substrate 130 is greater than the area of the transparent substrate 120. That is, the areas of the transparent substrates 120, 130 increase toward the window 141. In other words, the areas of the substrates 110, 120, 130 increase in order from the first organic EL device 11 toward the second organic EL devices 12, 13.

With this structure, light that takes an oblique direction with respect to the normal lines H11, H12, and H13 of the substrates 110, 120, and 130 is easily emitted outside the lighting apparatus 20.

As shown in Fig. 6, the housing 14 of the second lighting apparatus 20 may be widened toward the window 141 in accordance with the size of the substrates 110, 120, and 130. That is, the housing 14 becomes narrower toward the opposite side (lower side as shown in Fig. 6) of the light exiting portion, which is the window 141. By providing the above mentioned light reflective portion along the inner surface of the housing 14, part of or the entire light that was not emitted toward the window 141 from the organic EL devices 11, 12, and 13 is directed toward the window 141. Accordingly, the amount of light emitted outside the lighting apparatus 20 increases.

A third lighting apparatus 30 according to a third embodiment of the present invention will now be described. The third lighting apparatus 30 has the same structure as the first lighting apparatus 10 except that the areas of the organic EL elements 111, 121, and 131 are changed, and can be modified in the same manner as the first lighting apparatus 10.

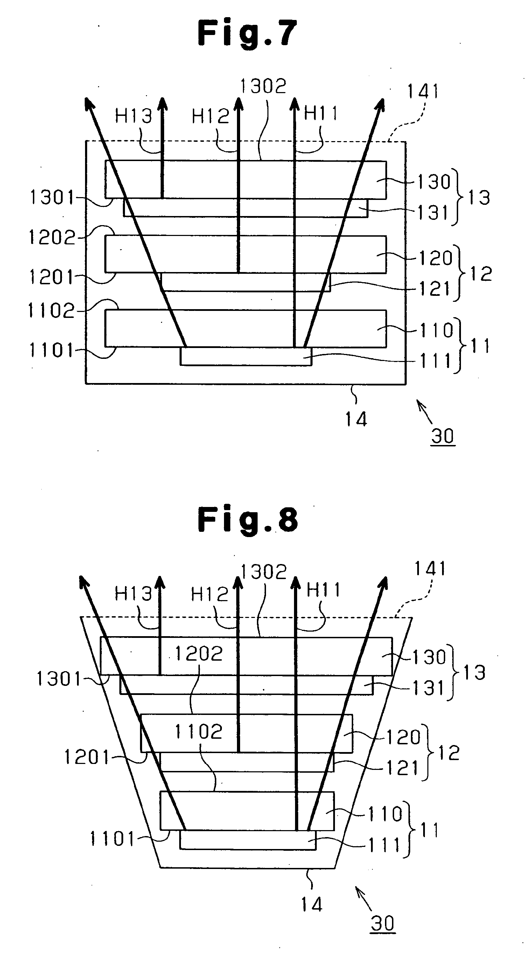

For example, as shown in Fig. 7, the area of the second organic EL element 121 is greater than the area of the first organic EL element 111. The area of the second organic EL element 131 is greater than the area of the second organic EL element 121. That is, the area of the organic EL elements 111, 121, and 131 increases toward the window 141. In other words, the area of the organic EL elements 111, 121, and 131 increases in order from the first organic EL device 11 toward the second organic EL devices 12, 13.

The contact surfaces 1101, 1201, and 1301 have contact portions that contact with the organic EL elements 111, 121, and 131. The organic EL elements 111, 121, and 131 are arranged such that the areas of the contact portions increase in order from the first organic EL device 11 toward the second organic EL devices 12, 13.

With this structure, light that takes an oblique direction with respect to the normal lines H11, H12, and H13 of the substrates 110, 120, and 130 is easily emitted outside the lighting apparatus 30.

In the same manner as the second lighting apparatus 20, the area of the substrates 120, 130 may increase toward the window 141.

For example, as shown in Fig. 8, the area of the organic EL elements 121, 131 and the area of the substrates 120, 130 increase toward the window 141. The housing 14 is preferably widened toward the window 141 in accordance with the size of the substrates 110, 120, and 130. That is, the housing 14 becomes narrower toward the opposite side (lower side as shown in Fig. 8) of the light exiting portion, which is the window 141. Furthermore, a light reflective portion is preferably formed along the inner surface of the housing 14. In this case, part of or the entire light that was not emitted toward the window 141 from the organic EL devices 11, 12, and 13 is directed toward the window 141. Therefore, the amount of light emitted outside the lighting apparatus 30 can increase.

The present examples and embodiments are to be considered as illustrative and not restrictive and the invention is not to be limited to the details given herein, but may be modified within the scope and equivalence of the appended claims.

A lighting apparatus includes a first organic electroluminescence device. The first organic electroluminescence device has a substrate, a first organic electroluminescence element, which is formed on the substrate, and a light emitting portion. At least one second organic electroluminescence device is stacked on the light emitting portion. The second organic electroluminescence device has a transparent substrate and a transparent second organic electroluminescence element, which is formed on the transparent substrate. Therefore, the lighting apparatus can freely set the illumination intensity.

## Claims

1. A lighting apparatus, **characterized by:**
a first organic electroluminescence device, the first organic electroluminescence device has a substrate, a first organic electroluminescence element, which is formed on the substrate, and a light emitting portion; and
at least one second organic electroluminescence device, which is stacked on the light emitting portion, the second organic electroluminescence device has a transparent substrate and a transparent second organic electroluminescence element, which is formed on the transparent substrate.

2. The lighting apparatus according to claim 1, **characterized in that** light emitted from the second organic electroluminescence device includes light having a wavelength that is substantially the same as the wavelength of light emitted from the first organic electroluminescence device.

3. The lighting apparatus according to claim 1, **characterized by** a housing for covering the first and second organic electroluminescence devices,
wherein the housing has a light exiting portion, which permits light emitted from the organic electroluminescence devices to be emitted outside the housing.

4. The lighting apparatus according to claim 3, **characterized by** a light reflective portion located in the housing.

5. The lighting apparatus according to claim 4, **characterized in that** the housing narrows toward the opposite side of the light exiting portion.

6. The lighting apparatus according to claim 3,
**characterized by** a light scattering member located in the housing.

7. The lighting apparatus according to claim 6, **characterized in that** the housing narrows toward the opposite side of the light exiting portion.

8. The lighting apparatus according to any one of claims 1 to 7, **characterized in that** the first and second organic electroluminescence devices are arranged such that the area of each of substrates increases in order from the first organic electroluminescence device toward the second organic electroluminescence device.

9. The lighting apparatus according to any one of claims 1 to 7, **characterized in that** the first and second organic electroluminescence devices are arranged such that the area of each of organic electroluminescence devices increases in order from the first organic electroluminescence device toward the second organic electroluminescence device.

10. The lighting apparatus according to any one of claims 1 to 7, **characterized in that** the area of the substrate of the second organic electroluminescence device is greater than the area of the substrate of the first organic electroluminescence device.

11. The lighting apparatus according to any one of claims 1 to 7, **characterized in that** the area of the second organic electroluminescence element is greater than the area of the first organic electroluminescence element.

12. The lighting apparatus according to any one of claims 1 to 7, **characterized in that** each substrate has a contact surface, which contacts the organic electroluminescence element, and a normal line of the contact surface of each substrate is substantially parallel to each another.

13. The lighting apparatus according to any one of claims 1 to 7, **characterized in that** the first organic electroluminescence element includes a luminous portion and a light reflective layer, which is located opposite to the light emitting portion with respect to the luminous portion.

14. The lighting apparatus according to any one of claims 1 to 7, **characterized in that** at least one of the first and second organic electroluminescence devices is formed by a plurality of organic electroluminescence devices arranged in a direction perpendicular to a direction from the first organic electroluminescence device toward the second organic electroluminescence device.
